# EUROPEAN PATENT SPECIFICATION

(11) **EP 1 932 244 B1**
(45) Date of publication and mention of the grant of the patent: **04.08.2010**
(21) Application number: 06814486.4
(22) Date of filing: 12.09.2006
(51) Int. Cl.: H04B 1/04, H03G 3/20

(54) **CONTROLLING POWER OUTPUT OF A TRANSCEIVER**
KONTROLLE DER STROMAUSGABE EINES SENDE-EMPFANGSGERÄTS
REGLAGE DE LA PUISSANCE DE SORTIE D'UN EMETTEUR-RECEPTEUR

(30) Priority: 26.09.2005 US 720412 P; 21.03.2006 US 385521
(43) Date of publication of application: 18.06.2008
(73) Proprietor: NXP B.V., 5656 AG Eindhoven (NL)
(72) Inventor: SHAN, Sheng-Ming, TX 78749 (US); SRIDHARAN, Srinath, TX 78739 (US)
(74) Representative: Style, Kelda Camilla Karen
(86) International application number: PCT/US2006/035396
(87) International publication number: WO 2007/037971

(56) References cited:
- EP-A- 1 341 300
- WO-A-2004/021659
- WO-A-2005/088922
- WO-A2-03/036896
- US-A1- 2005 054 308

## Description

### Field of the invention

The present invention relates to transceivers, and more particularly to controlling a transceiver to improve performance of a radio.

### Background

Transceivers are used in many communication systems including wireless devices, for example. A transceiver can be used for both transmit and receive operations in a device. Often, a transceiver is coupled between a baseband processor and an antenna and related circuitry of the system. In the receive direction, incoming radio frequency (RF) signals are received by the transceiver, which downconverts them to a lower frequency for processing by the baseband processor. In the transmit direction, incoming baseband data is provided to the transceiver, which processes the data and upconverts it to a higher frequency, e.g., a RF frequency. The upconverted RF signals are then passed to a power amplifier (PA) for amplification and transmission via an antenna.

Thus, the transceiver acts as an interface between digital and RF domains. Among the various tasks performed by a transceiver are downconversion and upconversion, modulation and demodulation, and other related tasks. Oftentimes, a transceiver is controlled by a baseband processor to which it is coupled.

In turn, the transceiver is coupled to a power amplifier, which generates appropriately conditioned, RF signals for transmission via an antenna. In the transmit direction, the transceiver provides RF signals to the power amplifier, which amplifiers the signals based on gain and ramp information for a given modulation type. Different wireless communication protocols implement different modulation schemes. For example, a Global System for Mobile communication (GSM) system can implement various modulation schemes, including a gaussian minimum shift keying (GMSK) modulation scheme for voice data. Furthermore, extensions to GSM, such as Enhanced Data rates for GSM Evolution (EDGE) use other modulation schemes, such as an 8 phase shift keying (8-PSK) modulation scheme.
US Patent 2005/0054308 describes a variable gain power amplifier that implements both GMSK and 8PSK modulation schemes.

While many different power amplifiers exist, most PAs receive various control signals, e.g., from the baseband processor, along with the data signal, e.g. from the transceiver. These control signals include an enable signal and the like. Also, a PA receives a supply voltage and/or one or more bias voltages. Some PAs in certain wireless protocols implement a linear architecture. These PAs can operate in dual modes of operation, namely a saturated mode and a linear mode. GMSK schemes typically transmit in a saturated mode in which transmitted data is output from the PA with a constant amplitude as measured by power versus time during the useful part of the burst. In contrast, 8-PSK modulation implements a linear mode in which a time-varying amplitude is output from the PA as measured by power versus time during the useful part of the burst.

In the 3GPP specification, a mixed mode of operation is set forth. This mixed mode of operation, otherwise known as a dual transfer mode, switches modulation schemes during inter-slot periods. Specifically, one implementation calls for transmission in alternating GMSK-8-PSK schemes in different slots. Control between the modulation schemes switches in the inter-slot period. Accordingly, the 3GPP specification requires that a switching spectrum be met in which power transients at the output of the power amplifier are reduced or eliminated in the inter-slot period to provide for proper operation.
WO 2004/021659 describes a transmitter which introduces dips in the guard time interval between adjacent time slots or bursts to avoid interference.
WO 2003/036896 discloses a transmitter that fully ramps a communication signal down and then back inside a guard period so that signal glitches only occur when the signal is ramped down and so can be made negligible.

As more service providers enable mixed mode operations, wireless systems need to improve their switching spectrum during the inter-slot period, particularly for mixed mode operations.

### Summary of the Invention

A first aspect of the present invention provides a method comprising transmitting radio frequency (RF) data of a first slot via an RF signal path from a transceiver to a power amplifier, squelching the RF signal path during a predetermined portion of an inter-slot period, and transmitting RF data of a second slot via the RF signal path from the transceiver to the power amplifier, wherein the squelching the RF signal path comprises squelching an RF output to a zero value by opening a switch on the RF signal path from the transceiver to the power amplifier. In addition to squelching the RF signal path, a ramp output of the transceiver may further be disabled during the predetermined portion.

Another aspect of the present invention provides an apparatus comprising a transceiver to receive baseband data and to provide radio frequency (RF) data to a power amplifier, wherein the transceiver is controllable to squelch an RF output during an inter-slot period between a first slot and a second slot of a multi-slot communication; wherein the transceiver comprises a switch coupled to a RF output line from the transceiver, and the apparatus comprises a controller to control the transceiver to squelch the RF output to a zero value by opening the switch. The apparatus may further include a baseband processor coupled to the transceiver that sends control information to the transceiver to disable a ramp output of the transceiver, and the baseband processor may further include a controller that controls squelching of the RF output.

Yet another aspect of the present invention provides a system comprising a transceiver to receive baseband data and control information and to provide radio frequency (RF) data to a power amplifier, wherein the transceiver is to squelch an RF output during an inter-slot period between a first slot and a second slot of a mixed mode multi-slot communication; a baseband processor to provide the baseband data and the control information; and a power amplifier coupled to the transceiver to receive the RF output; wherein the transceiver comprises a switch coupled to a RF output line from the transceiver, and the baseband processor is operable to squelch the RF output to a zero value by opening the switch.

### Brief Description of the Drawings

FIG. 1 is a block diagram of a portion of a wireless system in accordance with one embodiment of the present invention.

FIG. 2 is a timing diagram of a multi-slot transition in accordance with one embodiment of the present invention.

FIG. 3 is a timing diagram of a multi-slot transition in accordance with another embodiment of the present invention.

FIG. 4 is block diagram of a transceiver in accordance with one embodiment of the present invention.

FIG. 5 is a block diagram of a system in accordance with one embodiment of the present invention.

### Detailed Description

In various embodiments, a transceiver may be controlled to remove or squelch its RF output during certain portions of a communication cycle to avoid power transients at an output of a power amplifier to which the transceiver is coupled. Furthermore, in some implementations ramp control for the power amplifier may also be squelched during these portions of the communication cycle. Further, the ramp control may switch between baseband control for certain modulation schemes and transceiver control for other modulation schemes. While the following discussion refers to a mixed mode of operation, and more particularly a mixed mode of operation using GMSK and 8-PSK modulation schemes, it is to be understood that the scope of the present invention is not so limited.

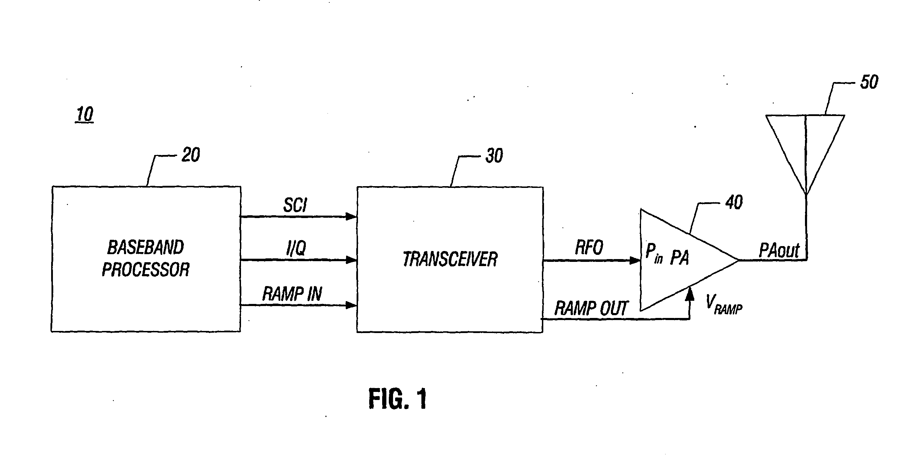

Referring now to FIG. 1, shown is a block diagram of a portion of a wireless system in accordance with one embodiment of the present invention. As shown in FIG. 1, system 10 includes a baseband processor 20. In various embodiments, baseband processor 20 may be responsible for processing data of a wireless communication, e.g., a voice and/or data communication. Furthermore, baseband processor 20 may provide control signals to other system components, such as a transceiver 30 to which it is coupled.

Baseband processor 20 provides wireless data to transceiver 30, e.g., in the form of I and Q signals. Furthermore, baseband processor 20 provides control signals to transceiver 30. In one embodiment, such control information may be sent via a serial control interface (SCI), although the scope of the present invention is not so limited. As further shown in FIG. 1, baseband processor 20 further provides a ramp signal to transceiver 30. In different implementations, a ramp digital-to-analog converter (DAC) within baseband processor 20 may generate the ramp signal and provide it to transceiver 30. The ramp signal may be used to ramp the transceiver up before a transmit burst and ramp it down after a transmit burst to improve signal performance, e.g., to prevent out of band spurious noise. Use of the ramp signal will be discussed further below.

Upon receipt of wireless data, transceiver 30 may perform various processing including, for example, frequency conversion and modulation according to a desired modulation scheme. Data may be transmitted out of transceiver 30 as RF output data (RFO), and in turn may be input to PA 40 as a power input signal (Pᵢₙ). Transceiver 30 is further coupled to provide a ramp output signal (RAMPOUT) which is input to PA 40 as V_{RAMP}. The amplified RF signals are then transmitted from PA 40 as a power output signal (PAₒᵤₜ) and are output from an antenna 50.

To reduce transients at an output of PA 40, transceiver 30 may be controlled to squelch its RF output at a predetermined time within the inter-slot period. In such manner, performance of system 10 may be improved and the spectral requirements for switching transients in a mixed mode of operation may be met. Still further, at this predetermined time of the inter-slot period, the ramp output from transceiver 30 may also be controlled to a zero value.

In different implementations, various manners of controlling the transceiver to enable this inter-slot silent period can be effected. In one implementation, control information from a baseband processor may be received in the inter-slot period and be used to trigger an RF squelch of the RF output signal and furthermore to clamp the ramp output signal to a ground or other reference level.

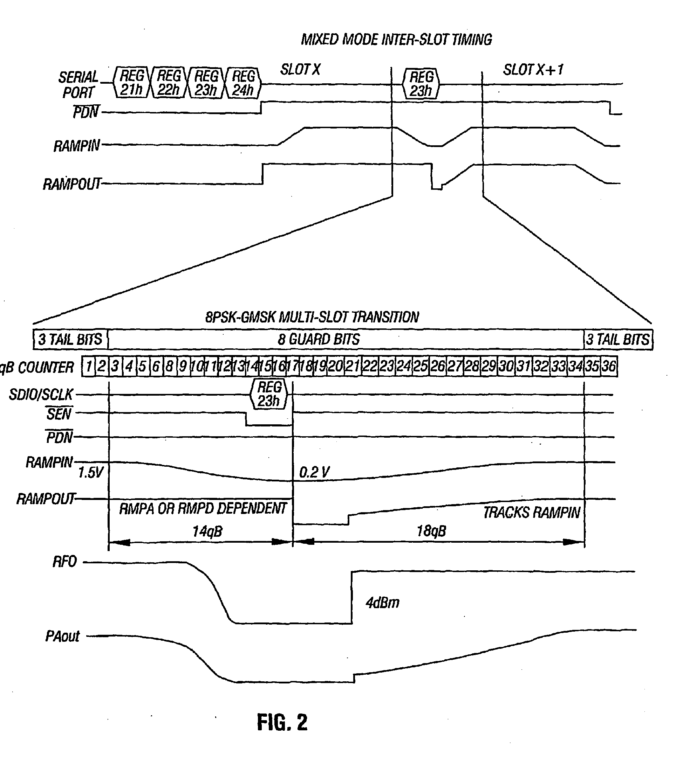

Referring now to FIG. 2, shown is a timing diagram of a multi-slot transition in accordance with one embodiment of the present invention. As shown in FIG. 2, a first slot (Slot X) is to be transmitted using 8-PSK modulation, while a second slot (Slot X+1) is to be transmitted using GMSK modulation. As shown in FIG. 2, control information corresponding to the contents of various registers is transmitted from a baseband processor and is received at a serial port of a transceiver. As shown in FIG. 2, the contents of various control registers may be transmitted to the transceiver via the serial port prior to the transmission time for the first slot. In the embodiment of FIG. 2, these control registers are enumerated as registers 21-24h. The contents of these registers may include various control information for data transmission. Such control information may include, e.g., a band indicator, channel numbers, automatic frequency control (AFC) fine tuning data, transmitter set up information, mode select data, among other such information. Of course, in other embodiments additional or different control information may be transmitted.

Still referring to FIG. 2, note that a power mask (PDN) is active for the entire multi-slot period. Note also that an incoming ramp signal (RAMPIN) from the baseband processor ramps up prior to the first slot, ramps down during the inter-slot period and further ramps up again prior to the second slot. However, in various embodiments the ramp output signal that is provided from the transceiver to the power amplifier (RAMPOUT) may be controlled to be squelched during a predetermined portion of the inter-slot period, additional details of which are discussed below.

FIG. 2 also shows a detailed inset of the inter-slot period. As shown, the inter-slot period is formed of a number of guard bits which are surrounded on both sides by a number of tail bits. The inset further shows that control information is received at the transceiver from the baseband processor (i.e., on serial data input/output lines (SDIO/SCLK)). Furthermore, an enable signal is received via another serial control line (SEN). When this enable signal transitions from a low state to a high state (i.e., at a quarter bit (qB) count of 17), the control information sent in the inter-slot period, namely data written into a selected register (i.e., register 23h in the embodiment of FIG. 2) from the baseband processor is applied. Specifically, this data may include control information to squelch the RF signal and clamp the ramp output.

Thus as shown in the inset of FIG. 2, the RF output (RFO) signal is squelched to a zero value. Accordingly, a corresponding output of the PA is also squelched, as shown in FIG. 2 (PA_{OUT}). While various manners of squelching the RF output signal from the transceiver are possible, in one embodiment an output buffer of the transceiver that conditions RF data for transmission may be disabled. In this embodiment, the control information sent from the baseband processor in the inter-slot period may include a disable bit to disable the output buffer. Accordingly, when this disable bit is activated via the SEN signal, the output buffer is disabled, thereby squelching the RF output. Disabling the output buffer may prevent output signals from a transceiver, while maintaining other circuitry of the transceiver in continued operation, such as a phase locked loop (PLL). Accordingly, no additionally settling time is needed to begin transmitting RF output data when the output buffer disable signal is deasserted.

Additional control information may be sent in the register during the inter-slot period. For example, the register may include ramp output values for use in an 8-PSK mode. Such values may include both digital and analog values, either of which may be used depending on a desired mode of operation. Furthermore, a gain value may be sent which may be used to control a variable gain amplifier (VGA) within the transceiver during 8-PSK operation. Still further, a mode bit may be transmitted to indicate the mode of operation for the next slot, e.g., 8-PSK or GMSK mode.

Of course, other manners of disabling the RF output signal may be accommodated. For example, the RF output line may be coupled to a switch, which is controlled based on control information, e.g., received from the transceiver. In yet other embodiments, the transceiver may include control logic to independently disable its RF output at the appropriate time. While such control logic may take many forms, in some implementations the logic may either receive a control signal from the baseband processor or, at the appropriate point in the inter-slot period, be programmed to effect disabling of the RF output, e.g., via disabling the output buffer, opening a switch or another such way.

Still referring to the inset of FIG. 2, when enabled by the control information during the inter-slot period, the ramp output signal is also controlled. Specifically, the ramp output signal (RAMPOUT) is also clamped to a zero value. In one embodiment, the mode select bit within the control information may be used to cause the ramp output signal to be clamped. However, different manners of squelching the ramp output signal may be effected in other embodiments.

In such manner, power transients may be reduced or removed from the output of the power amplifier. In the embodiment shown in FIG. 2, these squelch activities are active for four quarter bits, however, the scope of the present invention is not so limited. Accordingly, by providing an inter-slot silent period, improved power amplifier performance may be achieved, allowing a handset or other wireless device including the PA to pass qualification tests, such as spectral requirements for switching transients during a mixed mode multi-slot transmission.

In different modes of operation, the ramp output signal sent from the transceiver may be obtained and used differently. Specifically, in a GMSK mode, the voltage received by the transceiver at its ramp input pin (i.e., RAMPIN in FIG. 1) may be passed to its output (i.e., RAMPOUT in FIG. 1) to provide a ramp voltage to the power amplifier. In other words, the ramp output tracks the ramp input. In contrast, during an 8-PSK mode, the voltage received on the ramp input pin of the transceiver may be used to modulate the gain of the transceiver to achieve its ramping. Thus, the output ramp signal may be an independently controllable output, which is used to provide a bias voltage (i.e., at a fixed voltage) to the power amplifier for the 8-PSK mode of operation. In some implementations, transceiver 30 may include a switch, such as a single pole double throw (SPDT) switch to either provide the ramp signal received from the baseband processor 20 as the ramp output signal to PA 40 or to provide an independently-generated ramp output signal from transceiver 30 to PA 40.

Still referring to the inset of FIG. 2 after the inter-slot silent period, note that the ramp out signal begins tracking the input ramp signal (RAMPIN) from the baseband processor. Furthermore, note that the RF output signal switches from a squelched value to an active signal value, and the corresponding output of the PA also begins ramping up in preparation for the next communication slot.

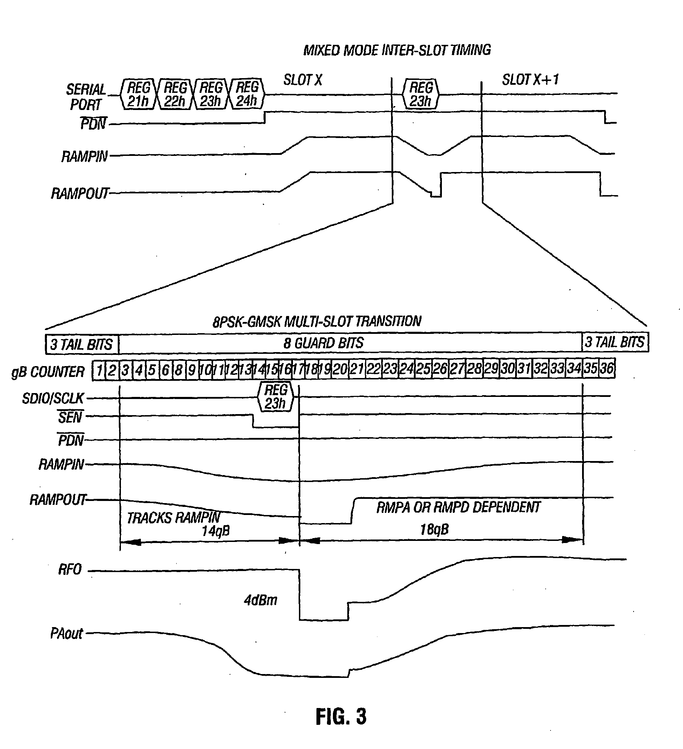

Referring now to FIG. 3, shown is a timing diagram of a multi-slot transition in accordance with another embodiment of the present invention. As shown in FIG. 3, a first slot (Slot X) is to be transmitted using GMSK modulation, while a second slot (Slot X+1) is to be transmitted using 8-PSK modulation. As shown in FIG. 3, transmission control information from a baseband processor to the transceiver may be the same as that described above with regard to FIG. 2. Note that in the embodiment of FIG. 3, before this inter-slot silent period, the ramp output signal tracks the ramp input signal received from the transceiver. However, after the inter-slot silent period, the ramp output signal during the 8-PSK mode does not track the ramp input signal. Instead, the ramp output signal may be dependent upon a ramp control value received, e.g., from the baseband processor. The RF output is squelched at a predetermined portion of the inter-slot period, as is the ramp output signal. After the inter-slot silent period, the RF output signal is again enabled, allowing the power amplifier to ramp up for transmission in the second slot.

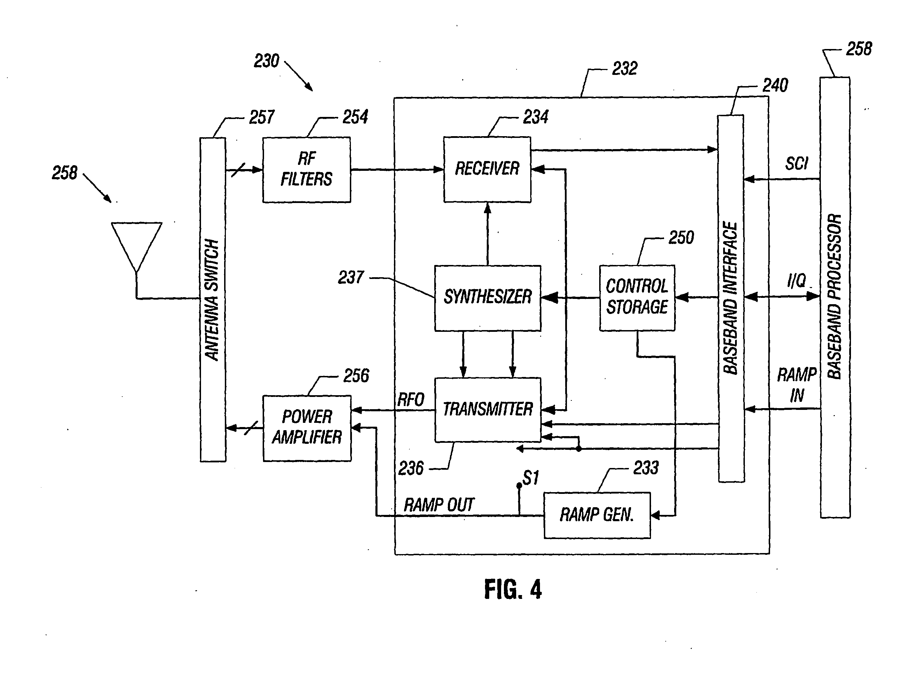

Referring now to FIG. 4, shown is block diagram of a transceiver in accordance with one embodiment of the present invention. Such a transceiver may be a CMOS transceiver for quad-band GSM/GPRS/EDGE wireless communications such as for use in cellular handsets and wireless data modems, although the scope of the present invention is not so limited.

As shown in FIG. 4, a transceiver 232 may be incorporated into a wireless system, such as the exemplary wireless system 230. Transceiver 232 may include a receiver 234 and a transmitter 236. Receiver 234 may be a heterodyne or a homodyne receiver may include a low intermediate frequency (IF) architecture. In some embodiments of the invention, transmitter 236 may be a direct up or heterodyne transmitter. For embodiments of the invention in which transmitter 236 is a heterodyne transmitter, the heterodyne transmitter may incorporate an offset phase locked loop (PLL) architecture.

Still referring to FIG. 4, a ramp generator 233 may generate ramp signals to be provided as the ramp output, e.g. for an 8-PSK mode of operation. Accordingly, a switch S 1 is coupled to select either the output of ramp generator 233 or the ramp input signal from baseband processor 258 to pass along as the ramp output signal to power amplifier 256. Furthermore, during 8-PSK operation, the incoming ramp signal from baseband processor 258 may be provided to transmitter 236 to modulate the gain.

As depicted in FIG. 4, in some embodiments of the invention, a synthesizer 237 of transceiver 232 may provide a radio frequency (RF) local oscillator signal to receiver 234; and furthermore, synthesizer 237 may provide both an RF local oscillator signal and an IF local oscillator signal to transmitter 236. Depending on the particular embodiment of the invention, synthesizer 237 may incorporate an RF PLL or an IF PLL or a combination of both of these components. The main function of synthesizer 237 is to provide local oscillator signals to receiver 234 and transmitter 236.

As further shown in FIG. 4, a baseband interface 240 forms an interface to a baseband processor 258, in some embodiments of the invention. Baseband interface 240 may be a digital interface, an analog interface or a combination of a digital and an analog interface, depending on the particular embodiment of the invention.

Also shown in FIG. 4 is a control storage 250 within transceiver 232. Control storage 250 may be coupled to receive and store various configuration and control information. As shown in FIG. 4, control storage 250 is further coupled to provide information therefrom to ramp generator 233, receiver 234, synthesizer 237 and transmitter 236. Furthermore, while not shown for ease of illustration in FIG. 4, configuration information from control storage 250 may further be coupled to power amplifier 256 and RF filters 254, an antenna switch 257 and an antenna 258, to control these components as desired.

While shown in FIG. 4 as including the particular components shown therein, it is to be understood that in other embodiments, transceiver 232 may include additional and/or different components, and the embodiment shown in FIG. 4 is for illustrative purposes.

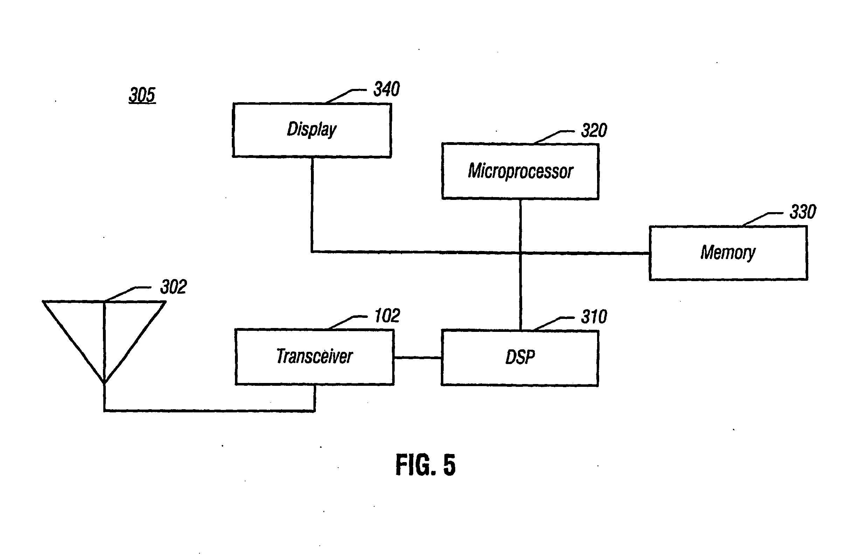

Referring now to FIG. 5, shown is a block diagram of a system in accordance with one embodiment of the present invention. As shown in FIG. 5, system 305 may be a cellular telephone handset, although the scope of the present invention is not so limited. For example, in other embodiments, the system may be a pager, personal digital assistant (PDA) or other such device. As shown, an antenna 302 may be coupled to a transceiver 102, such as the transceiver shown in FIG. 4. In turn, transceiver 102 may be coupled to a digital signal processor (DSP) 310, which may handle processing of baseband communication signals. In turn, DSP 310 may be coupled to a microprocessor 320, such as a central processing unit (CPU) that may be used to control operation of system 305 and further handle processing of application programs, such as personal information management (PIM) programs, email programs, downloaded games, and the like. Microprocessor 320 and DSP 310 may also be coupled to a memory 330. Memory 330 may include different memory components, such as a flash memory and a read only memory (ROM), although the scope of the present invention is not so limited. Furthermore, as shown in FIG. 5, a display 340 may be present to provide display of information associated with telephone calls and application programs. Although the description makes reference to specific components of system 305, it is contemplated that numerous modifications and variations of the described and illustrated embodiments may be possible. Furthermore, transceiver 102 may include an article in the form of a machine-readable storage medium (or may be coupled to such an article, e.g., memory 330) onto which there are stored instructions and data that form a software program. The software program may be implemented by transceiver 102 to perform activities according to control information received from DSP 310.

While the present invention has been described with respect to a limited number of embodiments, those skilled in the art will appreciate numerous modifications and variations therefrom. It is intended that the appended claims cover all such modifications.

## Claims

1. A method comprising:
transmitting radio frequency (RF) data of a first slot via an RF signal path from a transceiver (232) to a power amplifier (256);
squelching the RF signal path during a predetermined portion of an inter-slot period;
and
transmitting RF data of a second slot via the RF signal path from the transceiver to the power amplifier (256);
**characterised by**:
squelching the RF signal path comprises squelching an RF output to a zero value by opening a switch on the RF signal path from the transceiver to the power amplifier (256).

2. The method of claim 1, further comprising controlling the transceiver (232) to squelch the RF signal path.

3. The method of claim 1, further comprising disabling a ramp output of the transceiver (232) during the predetermined portion of the inter-slot period.

4. The method of claim 3, further comprising switching from a baseband control to a transceiver (232) control for the ramp output during the inter-slot period.

5. The method of claim 4, further comprising switching from the baseband control to the transceiver (232) control based on a mode select signal.

6. The method of claim 1, further comprising transmitting the RF data in a mixed mode, wherein the first slot comprises an 8-PSK modulation scheme and the second slot comprises a GMSK modulation scheme.

7. An apparatus comprising:
a transceiver (232) to receive baseband data and to provide radio frequency (RF) data to a power amplifier (256), wherein the transceiver is controllable to squelch an RF output during an inter-slot period between a first slot and a second slot of a multi-slot communication; and
**characterised by**:
the transceiver (232) comprises a switch coupled to a RF output line from the transceiver, and the apparatus comprises a controller to control the transceiver to squelch the RF output to a zero value by opening the switch.

8. The apparatus of claim 7, wherein the controller comprises a baseband processor (258) coupled to the transceiver (232) and wherein the baseband processor is to send control information to the transceiver (232) to squelch the RF output.

9. The apparatus of claim 8, wherein the baseband processor (258) is to send control information to the transceiver (232) to disable a ramp output of the transceiver (232).

10. The apparatus of claim 9, wherein the transceiver (232) is to switch the ramp output of the transceiver (232) from a first mode to a second mode upon receipt of the control information from the baseband processor (258).

11. A system comprising:
a transceiver (232) to receive baseband data and control information and to provide radio frequency (RF) data to a power amplifier (256), wherein the transceiver (232) is to squelch an RF output during an inter-slot period between a first slot and a second slot of a mixed mode multi-slot communication;
a baseband processor (256) to provide the baseband data and the control information;
and
a power amplifier (256) coupled to the transceiver (232) to receive the RF output;
**characterised in that**:
the transceiver (232) comprises a switch coupled to a RF output line from the transceiver, and the baseband processor is operable to squelch the RF output to a zero value by opening the switch.

12. The system of claim 11, wherein the transceiver (232) is to pass ramp control information from the baseband processor (258) to the power amplifier (256) in a GMSK mode of operation.

13. The system of claim 12, wherein the transceiver (232) is to generate the ramp control information in an 8-PSK mode of operation.

14. The system of claim 13, wherein the transceiver (232) is to squelch the ramp control information during the inter-slot period.

15. The system of claim 11, wherein the transceiver (232) further comprises:
a ramp generator (233) to generate a ramp output signal for the power amplifier (256);
and
a switch (51) coupled to pass an output of the ramp generator (233) or a ramp control signal from the baseband processor (256) to the power amplifier (256).

16. The system of claim 15, wherein the transceiver (232) is to modulate a gain of the RF output based on the ramp control signal during an 8-PSK mode of operation.

## Patentansprüche

1. Verfahren, umfassend:
Senden von Radiofrequenzdaten (RF-Daten) eines ersten Zeitschlitzes über einen RF-Signalpfad von einem Sende-Empfangsgerät (232) zu einem Leistungsverstärker (256);
Rauschsperre ("squelching") des RF-Signalpfads, während eines vorbestimmten Teils einer Zwischen-Zeitschlitzperiode;
und
Senden von RF-Daten eines zweiten Zeitschlitzes über den RF-Signalpfad vom Sende-Empfangsgerät zum Leistungsverstärker (256);
**dadurch gekennzeichnet dass**:
Rauschsperre des RF-Signalpfads, Rauschsperre einer RF-Ausgabe auf einen Nullwert durch Öffnen eines Schalters am RF-Signalpfad vom Sende-Empfangsgerät zum Leistungsverstärker (256) umfasst.

2. Verfahren nach Anspruch 1, das weiter Kontrolle des Sende-Empfangsgeräts (232) umfasst, um Rauschen des RF-Signalpfads zu sperren.

3. Verfahren nach Anspruch 1, das weiter Deaktivieren eines Rampenausgangs des Sende-Empfangsgeräts (232), während des vorbestimmten Teils der Zwischen-Zeitschlitzperiode, umfasst.

4. Verfahren nach Anspruch 3, das weiter Umschalten von einer Basisbandkontrolle auf eine Sende-Empfangsgerätkontrolle (232) für den Rampenausgang, während der Zwischen-Zeitschlitzperiode, umfasst.

5. Verfahren nach Anspruch 4, das weiter, auf einem Betriebsartwahlsignal beruhend, Umschalten von der Basisbandkontrolle auf die Sende-Empfangsgerätkontrolle (232) umfasst.

6. Verfahren nach Anspruch 1, das weiter Senden der RF-Daten in einem Mixed-Mode-Betrieb umfasst, wobei der erste Zeitschlitz ein 8-PSK-Modulationsprogramm umfasst und der zweite Zeitschlitz ein GMSK-Modulationsprogramm umfasst.

7. Vorrichtung, umfassend:
ein Sende-Empfangsgerät (232) zum Empfangen von Basisbanddaten und Bereitstellen von Radiofrequenzdaten (RF-Daten) an einen Leistungsverstärker (256), wobei das Sende-Empfangsgerät steuerbar ist, um Rauschen einer RF-Ausgabe, während einer Zwischen-Zeitschlitzperiode zwischen einem ersten Zeitschlitz und einem zweiten Zeitschlitz einer Multi-Zeitschlitz-Kommunikation, zu sperren; und
**dadurch gekennzeichnet dass**:
das Sende-Empfangsgerät (232) einen Schalter umfasst, der an eine RF-Ausgangsleitung vom Sende-Empfangsgerät gekoppelt ist und die Vorrichtung einen Kontroller zum Steuern des Sende-Empfangsgeräts umfasst, um Rauschen der RF-Ausgabe durch Öffnen des Schalters auf einen Nullwert zu sperren.

8. Vorrichtung nach Anspruch 7, wobei der Kontroller einen Basisbandprozessor (258) umfasst, der an das Sende-Empfangsgerät (232) gekoppelt ist und wobei der Basisbandprozessor Steuerinformation an das Sende-Empfangsgerät (232) senden soll, um Rauschen der RF-Ausgabe zu sperren.

9. Vorrichtung nach Anspruch 8, wobei der Basisbandprozessor (258) Steuerinformation an das Sende-Empfangsgerät senden soll, um einen Rampenausgang des Sende-Empfangsgeräts (232) zu deaktivieren.

10. Vorrichtung nach Anspruch 9, wobei das Sende-Empfangsgerät (232) den Rampenausgang des Sende-Empfangsgeräts (232), nach Empfang der Steuerinformation vom Basisbandprozessor (258), von einer ersten Betriebsart auf eine zweite Betriebsart schalten soll.

11. System, umfassend:
ein Sende-Empfangsgerät (232) zum Empfangen von Basisbanddaten und Steuerinformation und zum Bereitstellen von Radiofrequenzdaten (RF-Daten) an einen Leistungsverstärker (256), wobei das Sende-Empfangsgerät (232) Rauschen einer RF-Ausgabe, während einer Zwischen-Zeitschlitzperiode zwischen einem ersten Zeitschlitz und einem zweiten Zeitschlitz einer Multi-Zeitschlitz-Kommunikation der Mixed-Mode-Betriebsart, sperren soll; und
einen Basisbandprozessor (256) zum Bereitstellen der Basisbanddaten und der Steuerinformation; und
einen Leistungsverstärker (256), der an das Sende-Empfangsgerät (232) gekoppelt ist, um die RF-Ausgabe zu empfangen; **dadurch gekennzeichnet, dass**:
das Sende-Empfangsgerät (232) einen Schalter umfasst, der an eine RF-Ausgangsleitung vom Sende-Empfangsgerät gekoppelt ist und der Basisbandprozessor betriebsfähig ist, Rauschen der RF-Ausgabe durch Öffnen des Schalters auf einen Nullwert zu sperren.

12. System nach Anspruch 11, wobei das Sende-Empfangsgerät (232) Rampensteuerinformation vom Basisbandprozessor (258) in einer GMSK-Betriebsart an den Leistungsverstärker (256) übermitteln soll.

13. System nach Anspruch 12, wobei das Sende-Empfangsgerät (232) Rampensteuerinformation in einer 8-PSK-Betriebsart generieren soll.

14. System nach Anspruch 13, wobei das Sende-Empfangsgerät (232) die Rampensteuerinformation, während der Zwischen-Zeitschlitzperiode, sperren soll.

15. System nach Anspruch 11, wobei das Sende-Empfangsgerät (232) weiter umfasst:
einen Rampengenerator (233), um ein Rampenausgangssignal für den Leistungsverstärker (256) zu generieren;
und
einen Schalter (51), der gekoppelt ist, eine Ausgabe des Rampengenerators (233) oder ein Rampensteuersignal vom Basisbandprozessor (256) zum Leistungsverstärker (256) zu übermitteln.

16. System nach Anspruch 15, wobei das Sende-Empfangsgerät (232) eine Verstärkung der RF-Ausgabe, auf dem Rampensteuersignal basierend, während einer 8-PSK-Betriebsart modulieren soll.

## Revendications

1. Procédé comprenant :
la transmission de données radiofréquence (RF) d'une première tranche via un chemin de signaux RF d'un émetteur-récepteur (232) à un amplificateur de puissance (256);
le blocage automatique du chemin de signaux RF pendant une partie prédéterminée d'une période entre tranches ; et
la transmission de données RF d'une deuxième tranche via le chemin de signaux RF de l'émetteur-récepteur à l'amplificateur de puissance (256) ;
**caractérisé par :**
**le fait que** le blocage automatique du chemin de signaux RF comprend le blocage automatique d'une sortie RF sur une valeur zéro par l'ouverture d'un commutateur sur le chemin de signaux RF de l'émetteur-récepteur à l'amplificateur de puissance (256).

2. Procédé selon la revendication 1, comprenant en outre la commande de l'émetteur-récepteur (232) pour qu'il effectue le blocage automatique du chemin de signaux RF.

3. Procédé selon la revendication 1, comprenant en outre l'invalidation d'une sortie en rampe de l'émetteur-récepteur (232) pendant la partie prédéterminée de la période entre tranches.

4. Procédé selon la revendication 3, comprenant en outre la commutation d'une commande de bande de base vers une commande d'émetteur-récepteur (232) pour la sortie en rampe pendant la période entre tranches.

5. Procédé selon la revendication 4, comprenant en outre la commutation de la commande de la bande de base vers la commande de l'émetteur-récepteur (232) basée sur un signal de sélection de mode.

6. Procédé selon la revendication 1, comprenant en outre la transmission des données RF dans un mode mixte dans lequel la première tranche comprend un schéma de modulation 8-PSK et la deuxième tranche comprend un schéma de modulation GMSK,

7. Appareil comprenant :
un émetteur-récepteur (232) pour recevoir des données de bande de base et pour fournir des données radiofréquence (RF) à un amplificateur de puissance (256), cet émetteur-récepteur pouvant être commandé de façon à effectuer le blocage automatique d'une sortie RF pendant une période entre tranches entre une première tranche et une deuxième tranche d'une communication à plusieurs tranches ; et
**caractérisé par :**
**le fait que** l'émetteur-récepteur (232) comprend un commutateur couplé à une ligne de sortie RF venant de l'émetteur-récepteur, et que l'appareil comprend un contrôleur pour commander l'émetteur-récepteur afin qu'il effectue le blocage automatique de la sortie RF sur une valeur zéro en ouvrant le commutateur.

8. Appareil selon la revendication 7, dans lequel le contrôleur comprend un processeur de bande de base (258) couplé à l'émetteur-récepteur (232) et dans lequel ce processeur de bande de base doit envoyer une information de commande à l'émetteur-récepteur (232) pour qu'il effectue le blocage automatique de la sortie RF.

9. Appareil selon la revendication 8, dans lequel le processeur de bande de base (258) doit envoyer l'information de commande à l'émetteur-récepteur (232) pour invalider une sortie en rampe de l'émetteur-récepteur (232).

10. Appareil selon la revendication 9, dans lequel l'émetteur-récepteur (232) doit commuter la sortie en rampe de l'émetteur-récepteur (232) d'un premier mode sur un deuxième mode lors de la réception de l'information de commande envoyée par le processeur de bande de base (258).

11. Système comprenant :
un émetteur-récepteur (232) pour recevoir des données de bande de base et une information de commande et pour fournir des données radiofréquence (RF) à un amplificateur de puissance (256), cet émetteur-récepteur (232) devant effectuer le blocage automatique d'une sortie RF pendant une période entre tranches entre une première tranche et une deuxième tranche d'une communication à plusieurs tranches ;
un processeur de bande de base (256) pour fournir les données de bande de base et l'information de commande ; et
un amplificateur de puissance (256) couplé à l'émetteur-récepteur (232) pour recevoir la sortie RF ;
**caractérisé en ce que** :
l'émetteur-récepteur (232) comprend un commutateur couplé à une ligne de sortie RF venant de l'émetteur-récepteur, et le processeur de largeur de bande peut être actionné pour effectuer le blocage automatique de la sortie RF sur une valeur zéro en ouvrant le commutateur.

12. Système selon la revendication 11, dans lequel l'émetteur-récepteur (232) doit faire passer l'information de commande de rampe du processeur de bande de base (258) à l'amplificateur de puissance (256) dans un mode de fonctionnement GMSK.

13. Système selon la revendication 12, dans lequel l'émetteur-récepteur (232) doit produire l'information de commande de rampe dans un mode de fonctionnement 8-PSK.

14. Système selon la revendication 13, dans lequel l'émetteur-récepteur (232) doit effectuer le blocage automatique de l'information de commande de rampe pendant la période entre tranches.

15. Système selon la revendication 11, dans lequel l'émetteur-récepteur (232) comprend en outre :
un générateur de rampe (233) pour produire un signal de sortie en rampe pour l'amplificateur de puissance (256) ; et
un commutateur (51) couplé de façon à faire passer une sortie du générateur de rampe (233) ou un signal de commande de rampe du processeur de bande de base (258) à l'amplificateur de puissance (256).

16. Système selon la revendication 15, dans lequel l'émetteur-récepteur (232) doit moduler un gain de la sortie RF en se basant sur le signal commande de rampe pendant un mode de fonctionnement 8-PSK.
